# EUROPEAN PATENT APPLICATION

(11) **EP 4 625 468 A2**
(43) Date of publication of application: **01.10.2025**
(21) Application number: 25167342.2
(22) Date of filing: 31.03.2025
(51) Int. Cl.: H01J 37/21

(54) **AUTOMATIC CORRECTION OF ENERGY DEPENDENT DEFOCUS IN PARTICLE BEAM SYSTEMS DUE TO A CONFIGURATION CHANGE**

(30) Priority: 29.03.2024 US 202418622625
(71) Applicant: FEI Company, Hillsboro, OR 97124-5793 (US)
(72) Inventor: TIEMEIJER, Peter, Eindhoven (NL)
(74) Representative: Boult Wade Tennant LLP

(57) **Abstract**

Energy dependent defocus in electron beam systems due to a configuration change can be automatically corrected. A method implemented by an electron microscope system can involve receiving an electron beam from a transmission electron microscope. The transmission electron microscope can include an imaging system arranged after a sample plane. The electron beam can include an electron energy loss spectrum due to an interaction with a sample. The method can further involve focusing, by optical components of the energy spectrometer, the electron energy loss spectrum on a detector. Additionally, the method can involve determining information about a change in magnification of the imaging system. The method can involve adjusting, based on the change to the magnification, an operation of one or more optical components such that at least a portion of the electron energy loss spectrum is refocused onto the detector.

## Description

The present disclosure is directed to electron microscope system components, systems, and methods. More particularly, the present disclosure describes automatic refocusing of electron beams based on a detected configuration change in electron microscope systems.

### BACKGROUND

Charged particle microscopy, such as transmission electron microscopy (TEM), can use an array of detection techniques to obtain information about a sample. TEM techniques may be used to image various types of samples including interiors of cells, structures of protein molecules, organization of molecules in viruses and cytoskeletal filaments, etc. TEMs may use various techniques depending on the type of sample to be imaged. One such technique is called electron energy loss spectroscopy (EELS), where an electron beam emerging from a sample can be dispersed into an energy spectrum to be subsequently imaged. Unlike scanning electron microscopes (SEM) which only look at surface topography, TEM devices utilize the electron beam to pass completely through the sample to study interior topographies of the sample. Due to intrinsic laws of nature, electrons within the electron beam scatter after interacting with the sample. As a result, many of the electrons experience energy loss and, consequently, experience imaging plane focal shifts which requires adjusting the lensing optics in order to acquire a focused image. Accordingly, a degree of energy loss can be dependent on the scattered electrons, and a solution may be needed to achieve focused images for TEM devices that change configurations.

### BRIEF SUMMARY

The techniques described herein are directed to systems, detector apparatuses, and methods for automatically correcting energy dependent defocus in electron beams due to a configuration change. One embodiment is directed to a method implemented by an electron microscope system. The method can involve receiving an electron beam from a transmission electron microscope. The transmission electron microscope can include an imaging system arranged after a sample plane. The electron beam can include an energy loss spectrum due to an interaction with a sample. The method can further involve focusing, by optical components of the energy spectrometer, the electron energy loss spectrum on a detector. Additionally, the method can involve determining information about a change in magnification of the imaging system. The method can involve adjusting, based on the change in magnification, an operation of one or more optical components such that at least a portion of the electron energy loss spectrum is refocused onto the detector.

Another embodiment is directed to one or more computer-readable storage media. The one or more computer-readable storage media can store instructions that, upon execution by one or more processors of an energy spectrometer, can cause the energy spectrometer to perform operations. The operations can involve receiving an electron beam from a transmission electron microscope. The transmission electron microscope can include an imaging system arranged after a sample plane. The electron beam can include an energy loss spectrum due to an interaction with a sample. The operations can further involve focusing, by optical components of the energy spectrometer, the electron energy loss spectrum on a detector. Additionally, the operations can involve determining information about a change to a magnification of the imaging system. The operations can involve adjusting, based on the change to the magnification, an operation of one or more of optical components such that at least a portion of the electron energy loss spectrum is refocused onto the detector.

Still another embodiment is directed to an apparatus. The apparatus can include an energy spectrometer coupled to a transmission electron microscope to acquire one or more energy loss spectra. The transmission electron microscope can include an imaging system arranged after a sample plane. The energy spectrometer can include optical components. The optical components can focus an energy loss spectrum on a detector. The energy spectrometer can further include the detector arranged conjugate to a spectrum plane. Additionally, the energy spectrometer can include a controller. The controller can determine a change to a magnification of the imaging system. The controller can also adjust, based on the change to the magnification, an operation of one or more of the optical components such that at least a portion of the electron energy loss spectrum is refocused onto the detector.

### BRIEF DESCRIPTION OF THE DRAWINGS

The foregoing aspects and many of the attendant advantages of the present disclosure will become more readily appreciated as the same become better understood by reference to the following detailed description, when taken in conjunction with the accompanying drawings.
FIG. 1 is an example illustration of a portion of a microscope system as currently known in the art.
FIG. 2 is a schematic diagram of an electron microscope system, according to some embodiments.
FIG. 3 is a schematic diagram depicting an example of energy dependent defocus in an electron microscope system, according to some embodiments.
FIG. 4 is a set of images of various beam spectra of differing beam energies, according to some embodiments.
FIG. 5 is a schematic diagram depicting a electron microscope system with corrected energy dependent defocus, according to some embodiments.
FIG. 6 is a set of images of various beam spectra of differing primary beam energies after a correction to an energy dependent defocus, according to some embodiments.
FIG. 7 is a flow diagram of an example process for compensating for an offset shift across an energy loss spectrum, according to some embodiments.
FIG. 8 is an iterative flowchart diagram of an example process for operating an electron microscope system, according to some embodiments.
FIG. 9 is an example graph for cross-over shifts across an energy loss spectrum, according to some embodiments.
FIG. 10 is a flow diagram of an example process for operating a transmission electron microscope with an electron microscope system, according to some embodiments.
FIG. 11 is a block diagram of a controller for an electron microscope system according to certain aspects of the present disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

### DETAILED DESCRIPTION

Embodiments of the present invention are described below in the context of an electron microscope system including an electron microscope for acquiring energy spectra of a sample, where the electron microscope system can automatically make adjustments to correct an energy dependent defocus that can occur due to a configuration change. For example, depending on operating conditions and the configuration change, the excitation (electric or magnetic) of at least one optical component in the energy spectrometer can be adjusted to address the energy dependent defocus. The configuration change can involve a change in magnification settings for a portion of the electron microscope imaging system. However, it should be understood that the methods described herein are generally applicable to a wide range of different methods and apparatus, including both scanning-probe systems and parallel illumination systems, and are not limited to any particular apparatus type, beam type, object type, length scale, or scanning trajectory.

As used in this application and in the claims, the singular forms "a", "an", and "the" include the plural forms unless the context clearly dictates otherwise. Additionally, the term "includes" means "comprises". Further, the term "coupled" does not exclude the presence of intermediate elements between the coupled items.

The systems, apparatuses, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatuses are not limited to any specific aspect or feature or combinations thereof, nor do the disclosed systems, methods, and apparatuses require that any one or more specific advantages be present or problems be solved. Any theories of operation are to facilitate explanation, but the disclosed systems, methods, and apparatuses are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatuses can be used in conjunction with other systems, methods, and apparatuses. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one or ordinary skill in the art.

In some examples, values, procedures, or apparatuses are referred to as "lowest", "best", "minimum", or the like. It will be appreciated that such descriptions are intended to indicate that a selection among many used functional alternatives can be made, and such selections need not be better, smaller, or otherwise preferable to other selections.

Electron energy loss spectroscopy (EELS) is a detection technique typically incorporated into a transmission electron microscope (TEM) for analysis of compositional or other chemical properties of a sample. EELS is conventionally performed using an energy spectrometer mounted at an end of a column of the TEM. Such energy spectrometers may also be referred to as a post column filters (PCF). In some alternative examples, the spectrometer may be integrated in the imaging system of the TEM. Such alternative spectrometers may be referred to as in-column filters (ICF). The present disclosed method may apply to PCFs as well as to ICFs. Energy spectrometers can be used to obtain energy spectra of transmission data. For example, a sample (e.g., a substrate) in a TEM is interrogated with an electron beam of a desired energy. Some of the electrons exiting from the sample may have reduced energy thus characterizing various properties (e.g., nanostructures, topography, or similar) of the sample. The energy spectrometer may then be used to view an energy distribution of the electron beam after passing through the sample to look for peaks at various energy levels that provide data, e.g., various properties, of the sample material. Given current TEM and detector technology, the peaks can be highly resolved to millielectron volt levels, for example. However, imperfections in transmission electron microscopes may blur data such that desired resolution of the sample properties are reduced or lost. The loss of resolution may be due to a variety of factors, such as mechanical and electrical instabilities (vibrations), energy spread of the incoming beam due to the inherent energy spread of the electron source, finite resolution of the detector due to the finite size of its pixels, and chromatic defocusing of the electron beam as it propagates through portions (e.g., lenses, multipoles, or similar) of the transmission electron microscope and the energy spectrometer. The level of such defocus is electron energy dependent; but also changes depending on microscope settings, such as altering (increasing/decreasing) magnification settings of components of the microscope, energy spectrometer, or both, as the chromatic aberration of each lens, multipole (or similar) varies with its excitation. As higher resolution energy spectra are desired, chromatic defocusing can become a larger problem possibly necessitating frequent adjustments of the spectrometer, to a point that such adjustments are necessary as frequent as the frequency with which the user varies the magnification of the microscope system or the magnification of the energy spectrometer.

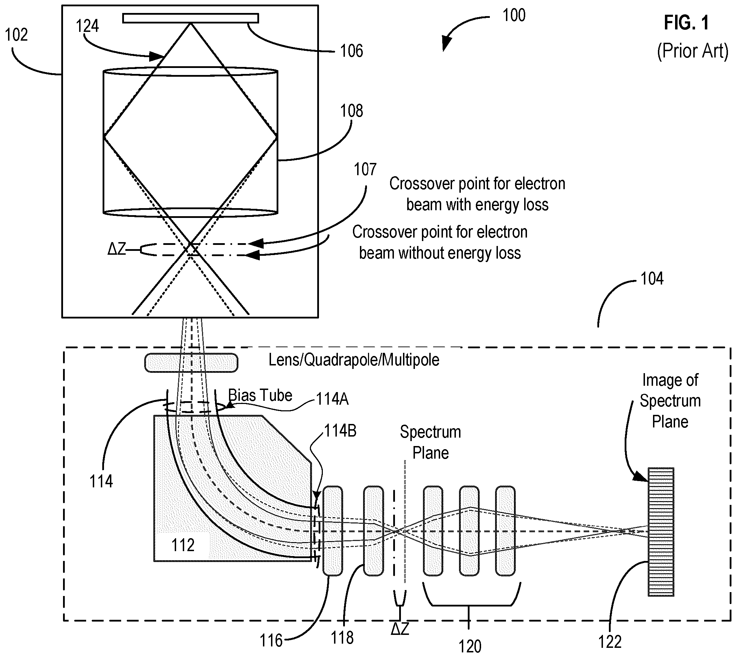

FIG. 1 is an example illustration of a portion of a microscope system 100 as currently known in the art. The microscope system 100 includes a portion of a transmission electron microscope 102 and an energy spectrometer 104. The microscope system 100 may be used to obtain energy spectra of a sample 106 but may suffer from defocusing of an electron beam 124 on detector 122 due to operating parameters of TEM 102 and energy spectrometer 104, such as magnification setting adjustments.

To illustrate, as electron beam 124 emerges from sample 106, the electron beam 124 takes a trajectory along an optical axis of the microscope 102. This trajectory can be dependent upon energy of electrons in the electron beam 124 and further can be dependent upon operating parameters of the microscope 102. The operating parameters can include operating parameters of an imaging system 108, for example, such as an adjustment of a magnification setting of the microscope 102 for magnification from the sample 106 towards a cross-over point 107 at an end of the microscope 102. Freedom of variation of this magnification is desirable for the user of the microscope system 100, because this magnification can determine how much a cone of electron beam 124 exiting the sample 106 is compressed towards the energy spectrometer 104. More compression can result in a larger part of the cone of the electron beam 124 being accepted by the spectrometer's entrance aperture. Operating parameters can determine excitation settings of optical components, such as lenses, multipole, and quadruple elements of the energy spectrometer 104. Operating parameters can change depending on energy of a primary electron beam, e.g., an energy of an electron beam used to interrogate the sample 106. However, due to sample-electron interaction, an electron beam emerging from the sample 106 may include some energy loss. The energy loss can be desirable, however, since measuring the loss at a range of energies by the energy spectrometer 104 can be beneficial for topological measurements. Yet, the energy loss can also affect crossover locations, e.g., focal points, of the electron beam 124 in the microscope 102 and the energy spectrometer 104. This change in crossover can result in a defocus of an electron beam spectrum on the detector 122.

For example, an electron beam propagating through microscope 102 without any energy loss may have a crossover location as indicated. However, an electron beam having some energy loss will have a different crossover location, with an offset ΔZ as indicated, which can propagate through the microscope 102 and the energy spectrometer 104.

The energy spectrometer 104 can include a lens 110 and a dispersive element 112. The dispersive element 112 can include a bias tube 114, lenses (e.g., lenses 116 and 118), a plurality of optical components (e.g., additional lenses, quadrupoles, multipoles, etc.) 120 and the detector 122. The dispersive element 112 can be energized to disperse or 'fan out' the electron beam 124 in a band of different energies that interact. The plurality of optical components 120 can focus and magnify the band on the detector 122. Typically, this band of different energies can be smaller than (e.g., may not cover) a complete range of an EELS spectrum which an operator may be interested in and may want to record. Therefore, the bias tube 113 can be electrically biased to add various amounts (e.g., up to two keV) of energy to the electron beam 124. The added energies can be used to shift the band recorded by the detector 122 (such shift of the energy band can also be accomplished by adjusting an excitation of the dispersive element 112 or by adjusting an operating potential of the electron microscope, such methods, however, can have a drawback of having relatively long settling times and/or of suffering from magnetic hysteresis). Due to an electrostatic nature, a liner tube can establish shifts from one energy band to another energy band in fractions of a millisecond, thus allowing near simultaneous recording of multiple energy bands (e.g., as described in U.S. Pat. No. 10,832,901 B2, incorporated herein by reference). The detector 122 may be arranged at a conjugate of a spectrum plane of the energy spectrometer 104 so that the electron beam 124 is focused on the detector 122.

The energy spectrometer 104 includes optical components, like multipoles, that may be configured to control (e.g., shape) the electron beam 124. The operations of these optical components (e.g., electrical currents that excite one or more of the multipoles magnetically) can be controlled to correct defocus based on the offset ΔZ. Various parameters such as magnification and constants of chromatic aberration may be determined for images detected at detector 122. Using these parameters, the operations of the optical components may be adjusted to correct defocus based on the offset ΔZ. Additionally, valid configurations of parameters may be tabulated for future use where certain configurations are commonly used or where specific configurations may need to be retrieved.

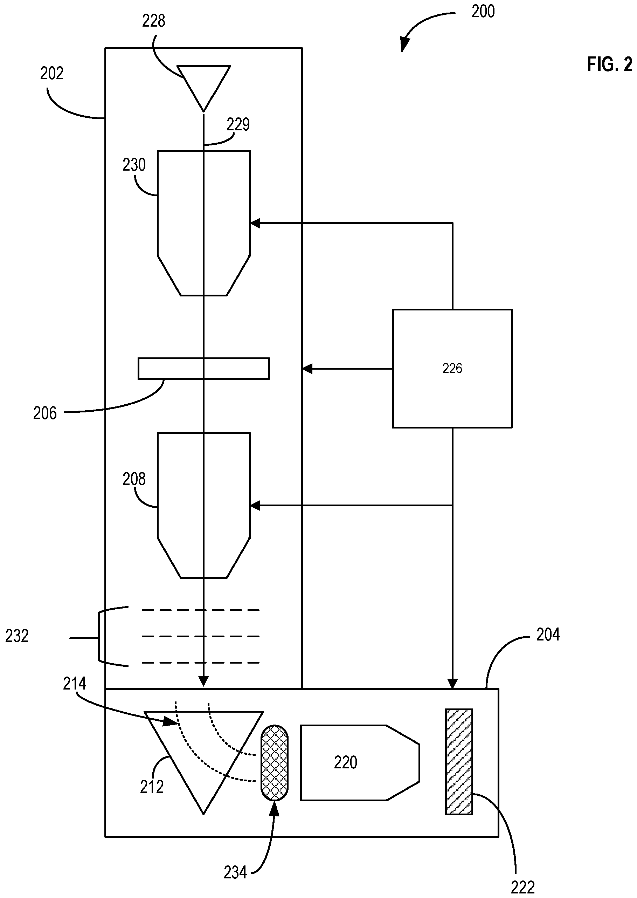

FIG. 2 is a schematic diagram of an electron microscope system (EMS) 200, according to some embodiments. EMS 200 may include a TEM 202 in some examples and can include an energy spectrometer 204. The energy spectrometer 204 may be used to obtain EEL spectra, for example. The EMS 200 may include an optical component to reduce or negate any defocusing problems that occur during acquisition of spectra. In some examples, the optical component can be biased to a level based on operating parameters of the EMS 200 and/or energy spectrometer 204 so that the refocusing is dynamic.

TEM 202 can include a source 228, an illumination system 230, a projection system 208, and various detectors 232, all of which can be controlled by controller 226. The source 228 may be an electron source, such as a Schottky source or a (cold) field emission gun (CFEG) and can provide a beam of electrons that propagate along an optical axis of TEM 202 to interact with a sample 206. The illumination system 230 can include a plurality of electronic optic components to condition an electron beam for delivery to the sample 206. Conditioning the electron beam may include collimation, astigmatism correction, and focusing the electron beam at a sample plane. The projection system 208 may include a variety of electrostatic/magnetic lenses, deflectors, correctors (e.g., stigmators), etc., that can be used to focus the electron beam emerging from the sample 206 onto one of the various detectors 232. The projection system 208 may be configured to focus an image of the sample 206 with a certain (adjustable) magnification at the detectors 232; this is commonly referred to as the "imaging mode" of the projection system. Alternatively, the projection system 208 may be configured to focus an image of the angular distribution of emerging electrons (or "diffraction pattern") with a certain (adjustable) magnification at the detectors 232. Such diffraction pattern is formed in the back-focal plane of the first magnifying lens (the "objective lens", not shown in FIG. 2). This alternative mode of the projection system is commonly called the "diffraction mode" and the magnification in this alternative mode is commonly referred to as the "camera length". However, for the sake of simplicity, where the present disclosure writes "images" or "focuses" or the like, this refers both to the "imaging mode" and to the "diffraction mode" of the imaging system. Similarly, where the present disclosure writes "magnification setting" or the like, this refers both to the "magnification setting" and "camera length setting" of the imaging system.

In some examples, the projection system 208 focuses and conditions the electron beam for delivery to the energy spectrometer 204. The various detectors 232 may individually be moved in and out of an optical path to provide different detection schemes for the TEM 202. The various detectors 232 may include an imaging screen, a TEM camera, and a STEM camera.

The energy spectrometer 204 can include dispersive element 212 (with bias tube 214), optical component 234, a plurality of optics 220, and detector 222. Many of the components of the energy spectrometer 204 were discussed with respect to FIG. 1 and will not be revisited for sake of brevity. Other components of the energy spectrometer 104 described in FIG. 1 that are not specifically shown in energy spectrometer 204 can be included but are left out of FIG. 2. An additional component, namely optical component 234, is included in energy spectrometer 204 to correct a gradient of focus of the electron energy loss spectrum across the detector as discussed. The optical component 234 can be a single element such as a magnetic hexapole. Alternatively, optical component 234 can comprise multiple multipole elements (quadrupoles, hexapoles, octupoles, and the like) which can be electric or magnetic in the nature of their operation. Also, apart from the refocusing of the spectrum, the optical component 234 may perform multiple alternative functions simultaneously or not simultaneously, such as correcting image distortions or correcting spectrum distortions. In FIG. 2, optical component 234 is shown downstream from dispersive element 212, but this is not the only location to arrange the optical component 234. In general, some elements of optical component 234 can be arranged upstream from the dispersive element 212 (but downstream from the sample 206), and some elements of the optical component 234 can be arranged downstream of the dispersive element 212 within or after the plurality of optics 220.

Controller 226 may include one or more processing cores and memory storing executable code. In addition, controller 226 may provide operating voltages to some components of the EMS 200 or be coupled to voltage supplies (not shown) that can provide operating voltages in response to control signals provided by the controller 226. For example, the controller 226 may provide control and/or voltages to illumination system 230, projection system 208, or optical component 234. Further, the controller 226 may control operation of detector 222 and/or receive data from detector 222. In general, the controller 226 can set the operating parameters of the EMS 200 and can adjust electrical bias of optical component 234 to dynamically focus the electron beam onto detector 222 in response to changes in operating conditions of the EMS 200, such as magnification.

Optical component 234 may be formed from a multipole element containing two or more electrically conductive elements. In some examples, optical component 234 is formed from two opposing conductive elements, similar to a deflector-or shutter-type arrangement, housed in a conductive body. In other examples, the optical component 234 is formed from a quadrupole or higher order multipole element. The excitation of optical component 234 can be of electric or magnetic nature or a combination of these, or more generally, can be of an electromagnetic nature. Regardless of the physical example, the optical component 234 may be excited to a level based on operating parameters of TEM 202 and/or energy spectrometer 204..

In operation, an electron beam generated by source 228 at a primary energy can be projected toward sample 206, where the electron beam interacts with the sample 206. The interaction may result in some of the electrons losing energy by an amount associated with various material characteristics of the sample 206. The electron beam emerging from the sample 206 may then include electrons of different energies across a range of energies. The emerging electron beam may then propagate at different trajectories than the electrons of the primary energy, which can affect focal points, e.g., crossover locations, along a rest of the optical path including the energy spectrometer 204 and the TEM 202. In some examples, operations of any component that may adjust (steer) the electron beam may subsequently result in defocusing in the spectrum plane or may result in a gradient of focus across the spectrum plane. In this example, to refocus the electron beam, the optical component 234 can be excited based on current operating parameters. In various examples, exciting the optical component 234 can align cross-over locations with the spectrum plane, and thus the detector 222.

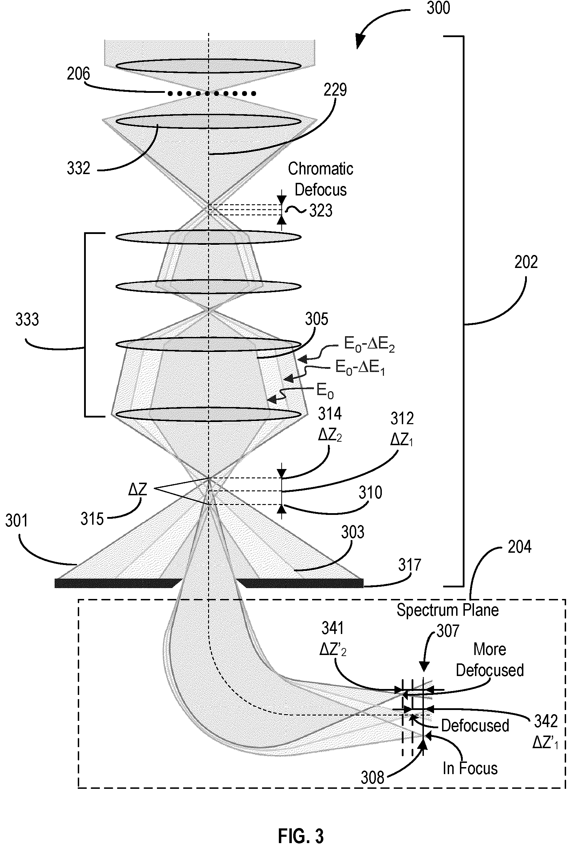

FIG. 3 is a schematic diagram depicting an example of energy dependent defocus in an electron microscope system 300, according to some embodiments. The electron microscope system 300 may incorporate some or all components of EMS 200 in Figure 2 (e.g., electron microscope system). By way of an example, an electron beam 229 may interrogate a sample 206 along an optical axis of a transmission electron microscope 202 (e.g., a TEM 202). The electron beam 229 may interact with the sample 206 causing electrons within the electron beam 229 to gain various attributes such as energy loss resulting in scattering (e.g., inelastic or similar) substantially along an optical axis. In some examples, the electron beam 229, which was scattered by the sample 206, passes through an objective lens 332 which may result in chromatic defocus (e.g., chromatic aberration) for charged particles that have varying energies.

In some examples, electron trajectory shifts can be dependent upon the energy of electrons in the electron beam 229, and further can be dependent upon operating parameters of the microscope such as magnification. By way of example, the operating parameters can include an adjustment of a magnification setting (e.g., adjusting the amount of expansion of an electron beam) of magnification elements 333 from the sample 206. Magnification elements 333 may include any number of intermediate lenses that may aide in magnifying operations to obtain an image. In an example, magnification can determine how much a cone of the electron beam 229 exiting the sample 206 is compressed towards an energy spectrometer 204. More compression can result in a larger part of the cone of the electron beam being accepted by a transmission electron microscope aperture 317 thus increasing signal and, by that, accuracy. On the other hand, less compression can be required if only specific sub-parts of the cone must be sampled by the energy spectrometer. However, in some examples, the magnification elements 333 may propagate, and in some examples magnify, the chromatic defocus 323 resulting in a cross-over location difference ΔZ 315.

In an example, the cross-over location difference ΔZ 315 may be defined as a difference between a first cross-over location 310 and a second cross-over location 312 or a third cross-over location 314. While cross-over locations 310-314 are shown, it should be understood that any number of cross-over locations may exist depending on charged particle energies (e.g., trajectories). In addition, the cross-over location difference ΔZ 315 may be at least partially dependent on operating parameters of the transmission electron microscope 202 and energy loss shifts of various charged particles within the electron beam 229. For example, the chromatic defocus 323 introduced by the objective lens 332 may be magnified by the magnification elements 333 resulting in a characteristic chromatic aberration spanning the cross-over location difference ΔZ 315 as discussed above. In some examples, increasing the magnification of the magnification elements 333 by controlling distance between intermediate lenses may increase a magnitude of the cross-over location difference ΔZ 315. In other examples, decreasing the magnification of the magnification elements 333 by controlling distance between intermediate lenses may decrease a magnitude of the cross-over location difference ΔZ 315. The magnitude of change of the cross-over location difference ΔZ 315 may be additionally dependent on specific energies of charged particles propagating along the optical axis.

Due to sample-charged particle interactions (e.g., scattering, x-ray emissions, or similar), the electron beam 229 emerging from the sample 206 may experience varying degrees of energy loss which can later shift the image away or toward a spectrum plane 307 (e.g., imaging plane) of the energy spectrometer 204. For example, an energy *E*₀ of a primary electron beam 305, e.g., a subsequent energy of the electron beam 229 without interrogating the sample 206 (e.g., what the electron beam would look like with the sample 206 removed), will have several cross-over locations as the charged particles undergo lensing operations through the transmission electron microscope 202. In some examples, the primary electron beam 305 may be used to initially calibrate the projection system 208 of the transmission electron microscope 202 and optical components (e.g., multipoles such as hexapoles, octupoles, decapoles, or similar) of energy spectrometer 204 to obtain the image in spectrum plane 307.

Electron beams with varying energies, such as the primary electron beam 305 with energy *E*₀, and secondary electron beam 303 with energy *E*₀ - Δ*E*₁, and tertiary electron beam 301 with energy *E*₀ - Δ*E*₂, will each traverse separate trajectories substantially along the optical axis of the transmission electron microscope 202. Although three electron beams of three separate energies are depicted in FIG. 3, the electron beam can include any number of multiple beams of differing energies due to energy loss interactions with the sample 206. The energy loss can be desirable since measuring the energy loss by the energy spectrometer 204 can be beneficial in determining properties of the sample 206. Yet, the energy loss may affect focusing locations of the charged particles in the transmission electron microscope 202 and the energy spectrometer 204 as discussed above. This change in focus can result in a defocused image on a detector located conjugate to a spectrum plane 307.

For example, the primary electron beam 305 having energy *E*₀ propagates through the transmission electron microscope 202 and may have a first crossover location, e.g., focal point location, as indicated by a first cross-over location 310. The secondary electron beam 303 having some energy loss Δ*E*₁ compared to *E*₀ will have a different crossover location, indicated by a second cross-over location 312 with a distance offset Δ*Z*₁. Additionally, the tertiary electron beam 301 having some different energy loss Δ*E*₂ compared to *E*₀ will also have another crossover location, indicated by a third cross-over location 314 with an distance offset Δ*Z*₂. In an example, for a specified *E*₀, when Δ*E*₂ > Δ*E*₁, then Δ*Z*₂ > Δ*Z*₁. Since both distance offsets Δ*Z*₂ 312, Δ*Z*₁ 314 can propagate through the transmission electron microscope 202, the secondary electron beam 303 and the tertiary electron beam 301 can result in distance offset Δ*Z*'₂ 341 and distance offset Δ*Z*'₁ 342, respectively, within the detector. Δ*Z*₂ and Δ*Z*₁ may be greater than, equal to, or less than ΔZ'₂ and ΔZ'₁, respectively, depending on operation parameters (e.g., magnification, constant of chromatic aberration, or similar) as discussed above. However, any distance offset (e.g., any shift) between respective electron beams may result in defocusing and blurring of an image in the spectrum plane 307 when ΔZ'₂ is approximately not equal to ΔZ'₁; and similarly, where either ΔZ'₂ or Δ*Z*'₁ are not located at a distance approximately in-line with focal plane 308 where primary electron beam 305 is focused (e.g., all imaging focus points are not in same imaging plane).

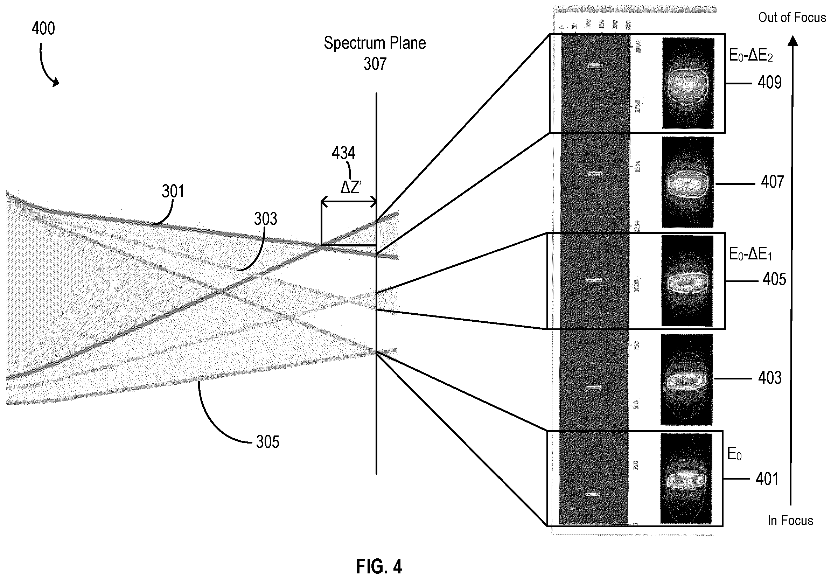

FIG. 4 is a set of images 400 of various beam spectra of differing beam energies, according to some embodiments. The set of images of various beam spectra of differing beam energies may represent some images from a point of view of the spectrum plane 307 of the transmission electron microscope 202 of Figure 3. The electron beam spectra images include images 401, 403, 405, 407, and 409 with electron beam energies decreasing from top to bottom. In an example, image 401 may represent a first image produced by primary electron beam 305 correctly focused in the spectrum plane 307, image 405 may represent a second image produced by the secondary electron beam 303 in the spectrum plane 307, and image 409 may represent a third image produced by the tertiary electron beam 301 in the spectrum plane 307. As shown, image 401 is in focus with clear contrast and minimal defocus and blurring. Image 405 is defocused with respect to image 401 with increased blurring and image 409 illustrates the largest amount of defocusing and blurring.

In addition to parameters related to magnification and imaging that may affect cross-over locations (e.g., chromatic aberrations), environmental factors such as temperature changes (e.g., a drop in ten degrees Celsius in a few hours) may alter cross-over locations over time (e.g., focus drift). For example, an image set acquired in a cold season may have a configuration (e.g., user defined or automatically defined by a computer) to obtain a focused image set. In contrast, if the configuration remains unaltered from the cold season into a hot season, the image set may not be in focus since some or all of the intermediate lensing components still have the cold season configuration (e.g., internal components calibrated at a colder temperature may operate differently than internal components calibrated at a warmer temperature). In one example, calibration of the transmission electron microscope 202 may involve adjusting (e.g., translation, rotation, or similar) one or more of the magnification elements 333 until at least one image from each image 401, 403, 405, 407, or 409 is in focus. As such, a change to a magnification setting and environmental factors of the transmission electron microscope 202 may lead to defocus of one or more of the images 401, 403, 405, 407, and 409 depending on a spread of energies in the electron beam 229, as discussed above.

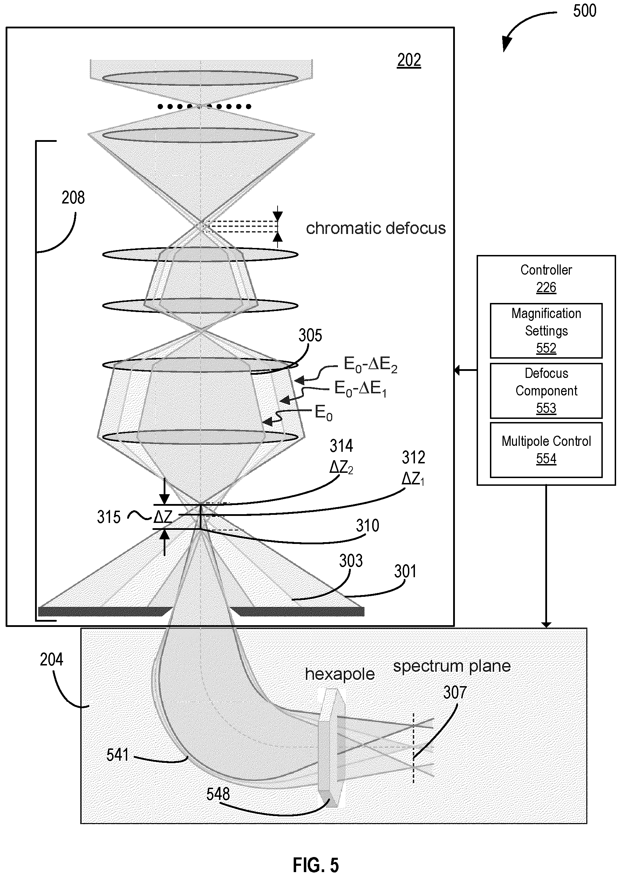

An optical component (now shown in FIG. 5) may include, for example, a set of (one or more) multipoles may be controlled to adjust one or more of the primary electron beam 305, the secondary electron beam 303, and the tertiary electron beam 301 in order to account for changes in charged particle energy loss, magnification, intermediate lensing components, the environmental factors, and focus drift over time. For example, the multipole set may shift one or more of the primary electron beam 305, the secondary electron beam 303, and the tertiary electron beam 301 to be substantially co-aligned (e.g., co-planar) with the spectrum plane 307 to aid in removing blur and defocus in at least one image from each image 401, 403, 405, 407, or 409 by reducing a cross-over distance ΔZ' 434 to be co-planar with the spectrum plane 307. In other examples, the multipole set may include several multipoles placed prior to the spectrum plane 307 and after (e.g., post) the spectrum plane 307.

FIG. 5 is a schematic diagram depicting an electron microscope system 500 with corrected energy dependent defocus, according to some embodiments. The electron microscope system 500 may include some or all components discussed in reference to the electron microscope system 300 of Figure 3 and/or the EMS 200 of Figure 2. An electron beam can emerge from a sample and the electron beam can take a trajectory along an optical axis of a transmission electron microscope 202, such as a TEM. This trajectory can be dependent upon energy of electrons in the electron beam and further can be dependent upon operating parameters of the transmission electron microscope 202 which may be controlled by the controller 226 (e.g., firmware, hardware, and/or software component(s) thereof).

In some examples, the controller 226 may store magnification settings 552 of the imaging system (including the projection system 208 and the objective lens) of the transmission electron microscope 202. For example, the controller 226 may adjust the magnification settings 552 to control some or all components (e.g., objective lens, condensers, magnification lenses, or similar) of the imaging system to achieve a desired focus of the electron beam. Freedom of variation of magnification is desirable for a user of the electron microscope system 500, because magnification can determine how much a cone of the electron beam exiting the sample is compressed towards an energy spectrometer 204. More compression can result in a larger part of the cone of the electron beam being accepted by the spectrometers entrance aperture.

In addition to the magnification settings 552, the controller 226 may also include a defocus component 553. The defocus component 553 may detect a defocus of the projection system 208 by using different techniques. The defocus can depend on many factors such as, but not limited to, a change to a magnification of the projection system 208 and/or operating parameters of the electron microscope system 500. The change to the magnification may be performed automatically by the controller 226 or by a user of the electron microscope system 500. The defocus component 553 may detect the change in magnification by receiving data indicating a particular magnification setting of the magnification settings 552 as being currently used. More generally, the defocus component 553 can detect a defocus using different techniques, such as any or a combination of: receiving the indication of the magnification change, receiving image data from an image detector(s) (e.g., detectors 232) and processing this image data using image analysis to detect the defocus, receiving data from an encoder connected to the magnification elements indicating a change to the magnification, and/or receiving data from a detector in the energy spectrometer 204 that monitors the spectrum plane 307 (e.g., the detector 222). In some examples, upon detecting a defocus, a multipole control component 554 of the controller 226 can be triggered to adjust operational parameters of the energy spectrometer 204, such as the optical component 548, such that the defocus is resolved.

In some examples, operating parameters can change depending on energy *E*₀ of a primary electron beam 305, e.g., an energy of the electron beam without interrogating the sample 206. However, due to sample-charged particle interactions, the electron beam emerging from the sample may include some energy loss. Thus, the electron beam can include multiple electron beams with varying energies, such as secondary electron beams 303 and tertiary electron beam 301. The multiple electron beams with varying energies can be referred to as an energy loss spectrum. Although electron beams of three separate energies are depicted in FIG. 5, the electron beam can include any number of multiple beams of differing energies due to energy loss interactions with the sample. The energy loss can be desirable since measuring the loss at a range of energies by the energy spectrometer 204 can be beneficial in determining material structures and composition. Yet, the energy loss can also affect cross-over locations of the electron beam in the transmission electron microscope 202 and the energy spectrometer 204.

For example, the primary electron beam 305 with energy *E*₀ propagating through the transmission electron microscope 202 and through the sample may experience some or no energy loss which may have a first cross-over location, e.g., focal point, as indicated by cross-over location 510. However, the secondary electron beam 303 having some energy loss Δ*E*₁ may have a different cross-over location, indicated by an offset Δ*Z*₁ 312, which can propagate through the transmission electron microscope 202 and the energy spectrometer 204. Additionally, the tertiary electron beam 301 having some different energy loss Δ*E*₂, may also have a different cross-over location, indicated by an offset Δ*Z*₂ 314, which can also propagate through the transmission electron microscope 202 and the energy spectrometer 204 when Δ*E*₂ > Δ*E*₁, then Δ*Z*₂ > Δ*Z*₁, for example. In this example, a cross-over focus difference ΔZ 315 between the primary electron beam 305 with energy *E*₀ and the tertiary particle beam 301 with energy Δ*E*₂ may be determined by the defocus component 553 and stored in memory.

In an example, the energy spectrometer 504 may include optical components, such as optical component 548, to shape the electron beam appropriately for imaging. In some examples, the optical component 548 may be any optical component usable to focus the electron energy loss spectrum 541. In some examples, the loss of focus at spectrum plane 307 may be approximated as having a linear dependence on the energy loss. In such uses, optical component 548 may include one or multiple hexapole elements. In other examples, energy losses may be higher and a linear approximation must be extended with higher order contributions (quadratic, cubic, in energy loss) to properly focus at the spectrum plane. In other examples, optical component 548 may include one or multiple hexapoles elements, one or multiple octupole elements, and the like. In Figure 5, the optical component 548 is shown as a hexapole to shift the cross-over locations of the primary electron beam 305, the secondary electron beam 303, and the tertiary electron beam 301 to be co-aligned in the spectrum plane 307 to form respective images. In this way, the use of optical component 548 as a multipole may be useful in compensating and correcting for chromatic aberrations and spherical aberrations by adjusting individual poles of the multipole until a focused image(s) can be formed from the electron energy loss spectrum 541.

By way of an example, an operation of the optical component 548 may be adjusted by the multipole control component 554 based on a type of the optical component 548. For example, if the optical component 548 is a hexapole that includes six separate excitable poles, then the hexapole may be adjusted, by the multipole control component 554, by exciting (e.g., applying current and/or voltage) three of the six poles at a first voltage and exciting the other three of the six poles at a second voltage. This adjustment of the hexapole may separately focus each of the electron beams 305, 303, and 301, into the same spectrum plane 307 for imaging. In other examples, if the optical component 548 is an octupole, one or more of the poles may be uniquely adjusted, based on an energy loss being larger than a threshold value, to achieve focused images that are absent of chromatic aberrations.

In some examples, the multipole control component 554 may adjust operations of the optical component 548 based on one or more parameters of the projection system 208, such as based on a change to the magnification settings 552 (e.g., increases or decreases to magnification). For example, if the user increases magnification of the transmission electron microscope 202, the cross-over locations 510, 512, 514 may shift accordingly (as discussed above). In response to the adjustment to the magnification setting 552 of the transmission electron microscope 202, an operation of the optical component 548 may be adjusted to compensate for defocusing or refocusing at least a portion of the electron energy loss spectrum 541 onto the detector (not shown) of the energy spectrometer 204. In some examples, an entirety of the electron energy loss spectrum 541 can be refocused onto the detector. The control of the optical component 548 can be effectuated based on a set of parameters. The parameters can include an amount of the adjustment to the magnification, M_{proj,} of the projection system 208, a constant of chromatic aberration C_{c}^{(proj)} of the projection system 208, the energy *E*₀ of the primary electron beam 305, a total energy spread ΔE of the electron energy loss spectrum, a cross-over location differences ΔZ between electron beams 301, 303, 305, etc. In some examples, controlling the optical component 548 can involve changing an electromagnetic field of the optical component 548. By way of an example, the cross-over location differences ΔZ 315 (e.g., a shift) may be determined at an end of the transmission electron microscope 202, and based on that determination an adjustment to an electromagnetic field of a multipole of the optical component 548 may be performed based on the cross-over location differences ΔZ.

While just one optical component 548 is depicted in FIG. 5, the energy spectrometer 204 can include several optical components. In an example, adjusting to correct for a chromatic defocus caused by a change in magnification settings 552 can involve adjusting the operations of multiple optical components. In some examples, the total energy spread ΔE can be compared to a predetermined threshold value for energy spread. The comparison can assist in determining adjustments of operations of multiple optical components. For example, if the total energy spread ΔE is less than the predetermined threshold value, then adjusting the operations can involve adjusting the operations of a first set of multipoles (e.g. at least one hexapole). If the total energy spread ΔE is larger than the predetermined threshold value, then adjusting the operations can involve adjusting the operations of a second set of multipoles (e.g., at least one hexapole and at least one octupole). The two sets may, but need not, include common multipoles. In other examples, adjusting the operation includes controlling a hexapole of optical components 548 based on an energy loss being smaller than a threshold value. In further examples, adjusting the operation includes controlling an octupole of the optical components 548 based on an energy loss being larger than a threshold value.

Herein above, a defocus component 553 and a multipole control component 554 are described. Such components 553 and 554 can be implemented as software components of the controller 226. Such components 553 and 554 may be optional. For example, as described herein below, a look-up table can be pre-stored and used. In this case, the components 553 and 554 may not be used. This look-up table can associate different parameters together to enable the refocus of the electron energy loss spectrum 541. In this case, a software component of the TEM can determine a new setting of the imaging system and inform a software component of the energy spectrometer 204 about the new setting. In turn, the software component of the energy spectrometer 204 can use the look-up table to determine, for the new setting, the controls that need to be applied to the energy spectrometer 204 such that the electron energy loss spectrum 541 is refocused properly. Depending on the implementation of the electron microscope system 500, such two software components can be part of the controller 226 or can be separate components, one specific to a controller of the TEM and one specific to the controller of the energy spectrometer 204.

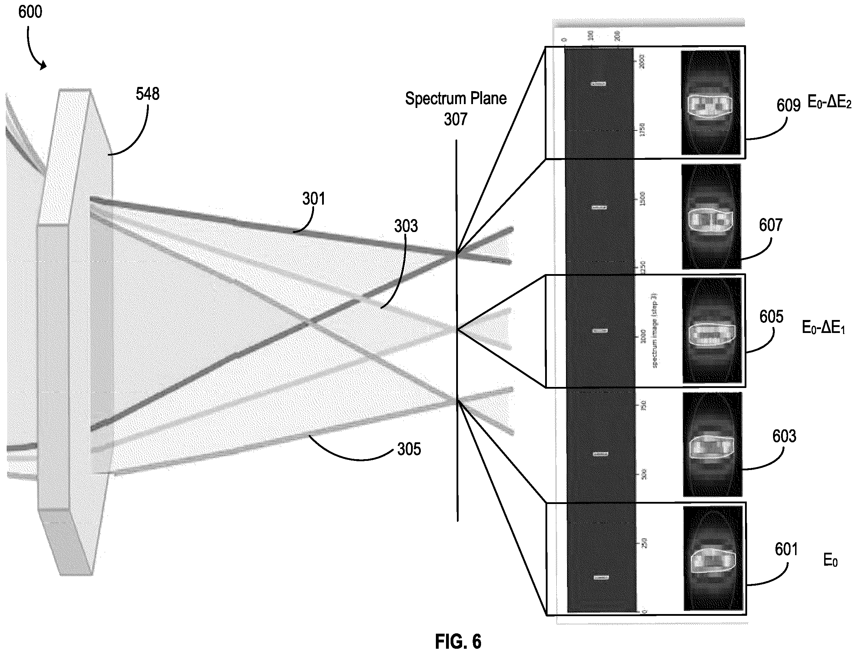

FIG. 6 is a set of images of various beam spectra 600 of differing primary beam energies after a correction to an energy dependent defocus, according to some embodiments. The set of images of various beam spectra 600 of differing beam energies may represent some images from a point of view of the spectrum plane 307 of the transmission electron microscope 202 of Figure 5. The beam spectra images include images 601, 603, 605, 607, and 609 with beam energies increasing from top to bottom. As discussed above, an adjustment of an operation of at least one optical component 548 of an energy spectrometer can correct a defocus (i.e., place the focus position at a common spectrum plane 307) in each of the primary electron beam 305 with energy *E*₀ in image 601, and secondary electron beam 303 with energy *E*₀ - Δ*E*₁ in image 605, and tertiary electron beam 301 with energy *E*₀ - Δ*E*₂ in image 609. Images 603 and 607 may depict intermediate electron beams (not shown).

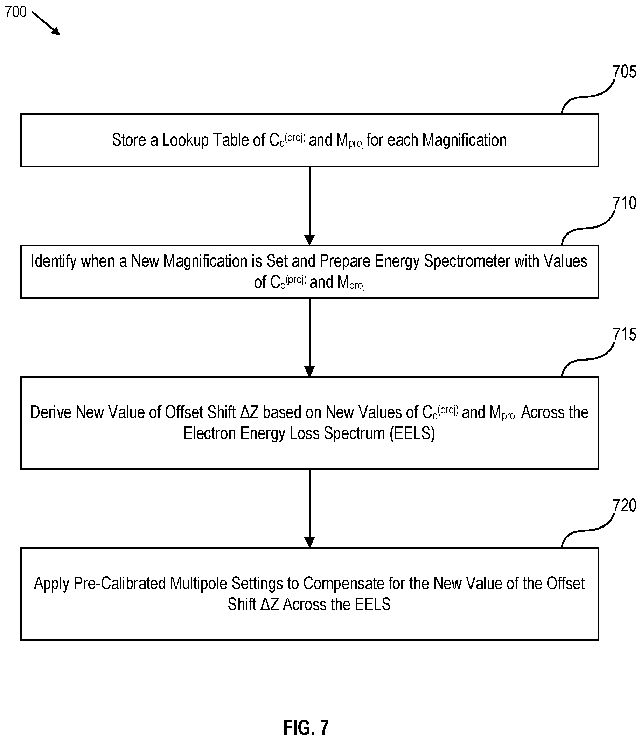

FIG. 7 is a flow diagram of an example process 700 for operating a transmission electron microscope with an electron microscope system, according to some embodiments. The electron microscope system may be an example of other electron microscope systems described herein, including electron microscope system 500 of FIG. 5.

The example process 700 begins at step 705 where a controller (e.g., software of the TEM) may store a look-up table of parameters. The parameters can include and associate setting parameters and control parameters. Given certain values of the setting parameters, the look-up table can be used to determine associated values of the control parameters. The setting parameters can be those of optical components of an imaging system of the electron microscope system (e.g., an objective lens and/or lenses of the projection system 208). The control parameters can be used to control the energy spectrometer 204, as further described herein below. In an example, the setting parameters can include but may not be limited to the magnification, Mₚᵣₒⱼ, of the projection system 208 and one or more constants of chromatic aberration C_{c}^{(proj)} (such as linear, quadratic, or cubic chromatic aberrations) of the projection system 208. The control parameters can include offset shifts (ΔZ) and/or electrical controls (e.g., current, voltage, etc.) for one or more optical components (e.g., multipole(s)) of the energy spectrometer 204. The values of the control parameters can be derived using a pre-calibration process. For instance, during the pre-calibration process, certain values of the setting parameters are used. Given these values, the pre-calibration process derives the values of the control parameters such that the electron microscope system is focused correctly (e.g., the offset shifts (ΔZ) are zero or about zero, or conversely, the variation to a focus across the electron energy loss spectrum is corrected and the electron energy loss spectrum is refocused onto a detector). The pre-calibration process can be repetitive such that the values of the control parameters are determined across the range of values of the setting parameters. The look-up table is one example of a data structure for storing and associating the different parameters. Of course, other data structures are possible, such as a list, an array, a database, etc.

At step 710, the controller (e.g, software of the TEM) may identify when a new setting of the imaging system has been set. The setting can correspond to one or more values of the setting parameters described at step 705 (e.g., a new value of the magnification, Mₚᵣₒⱼ, and/or a new value of the constant or constants of chromatic aberration C_{c}^{(proj)}). Subsequently, the controller (e.g, software of the TEM) may prepare the energy spectrometer 204 (e.g., by informing the software of the energy spectrometer 204 of the new setting, such as the new value of the magnification, Mₚᵣₒⱼ, and/or the new value of the constant(s) of chromatic aberration C_{c}^{(proj)}.

At step 715, the controller (e.g., software of the energy spectrometer 204) may use the look-up table to derive new values of the offset shift ΔZ across the electron energy loss spectrum 541 given the new setting (e.g., the new Mₚᵣₒⱼ and/or the new C_{c}^{(proj)}). These new values can be associated in the look-up table with the new setting, as described herein above, and indicate the new defocus across the electron energy loss spectrum 541. Other techniques are also possible to derive the new values of the offset shift ΔZ without relying on a look-up table. For example, a detector in the spectrum plane 307 may relay the images (e.g., similar to images 405 and 405 in Figure 4) to the controller 226 for analysis by the defocus component 553. The defocus component 553 may determine, based on the values of Mₚᵣₒⱼ and C_{c}^{(proj)}, that the images are not in focus and that a new value of the distance offset shift ΔZ needs to be calculated to bring some or all of the electron energy loss spectrum 541 into focus in the spectrum plane 307.

At step 720, the controller (e.g., software of the energy spectrometer 204) may apply pre-calibrated multipole settings (e.g., settings applied to some or all of the optical components 548) to compensate for the new value of the distance offset shift ΔZ across the electron energy loss spectrum 541. In an example, the look-up table may also associate the electrical controls (e.g., current, voltage, etc.) of one or more optical components (e.g., multipole(s)) of the energy spectrometer 204 with the new values of the offset shift ΔZ. As such, the look-up table can return the electrical controls that the energy spectrometer 204 then applies to the relevant optical components thereof. For instance, a particular excitation current and/or voltage are applied to a multipole in order to compensate for the new value of the distance offset shift ΔZ across the electron energy loss spectrum 541. In this example, adjusting an operation (e.g., exciting the poles) of the optical components 548, based on the change to the magnification (e.g., magnification setting change), such that variation to a focus across at least a portion of the electron energy loss spectrum 541 is corrected may ensure that at least the portion of the electron energy loss spectrum 541 is refocused onto the detector (e.g., using the same or similar to the techniques described in Figure 6). Here also, other techniques are also possible to derive the electrical controls without relying on a look-up table. For example, while operations of the multipoles are controllably adjusted, the detector in the spectrum plane 307 may relay resulting images (e.g., similar to images 405 and 409 in Figure 4) to the controller 226 for analysis by the defocus component 553. The defocus component 553 may determine, based on the operational adjustments, whether the images are in focus. This process can be iteratively repeated until the images become in focus, at which point the operational adjustments to the multipoles can be stopped.

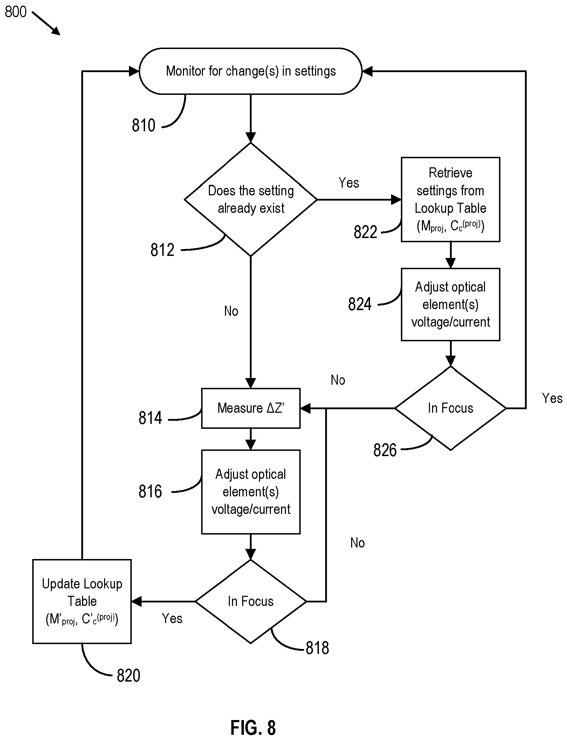

FIG. 8 is an iterative flowchart diagram of an example process 800 for operating an electron microscope system, according to some embodiments. The electron microscope system may be an example of other electron microscope systems described herein, including electron microscope system 500 of FIG. 5. The electron microscope system can include the controller 226 configured to carry out the operations of process 800. The process 800 begins at step 810 where the controller 226 monitors the transmission electron microscope 202 for a change in settings. In some examples, the change in settings may include a change in magnification, Mₚᵣₒⱼ, of the projection system 208. That is, where one or more magnification elements 333 have been adjusted by a user of the electron microscope system 500 or automatically by the controller 226 in response to pre-determined information (e.g., start-up processes, calibration, or similar). In addition, the change in settings may include information relating to constants of chromatic aberration, C_{c}^{(proj)}, of the projection system 208, a constant of chromatic aberration of an objective lens of the projection system 208, a change in an energy spectrum, or any combination thereof.

At step 812, the controller 226 determines if the change of settings is new or has occurred previously during a prior operation of the electron microscope system 500. The controller 226 may review a look-up table containing information and settings related to previously determined magnification element 333 positions, previously determined changes in magnifications Mₚᵣₒⱼ of the projection system 208, objective lens 332 positions, previously determined constants of chromatic aberration, C_{c}^{(proj)} , of the projection system 208, previously determined constants of chromatic aberration of objective lens 332 of the projection system 208, previously determined changes in the energy spectrum, previously determined multipole configuration settings for the optical component(s) 548, previously analyzed images from the defocus component 553, or combinations thereof to determine if an approximate match exists.

If controller 226 determines that no match exists in the look-up table, the process 800 continues to step 814 where the controller 226 uses the defocus component 553 and the multipole control component 554 to determine an offset ΔZ' 434 as shown in Figure 4. In some examples, offset ΔZ' 434 may be approximately equal to distance offset ΔZ 315 depending on a configuration of the projection system 208. In other examples, offset ΔZ' 434 may be different than distance offset ΔZ 315 as discussed above. In some examples, the controller 226 determines the offset ΔZ' 434 by analyzing images in the spectrum plane 307 in the current setting. The controller 226 may analyze the offset ΔZ' 434 to determine if a similar offset exists in the look-up table to arrive at a "best guess" initial multipole configuration. For example, the controller 226 may locate a previously determined constant of chromatic aberration for magnification Mₚᵣₒⱼ for a configuration (e.g., magnification element 333 positions, objective lens 332 position, or similar) of the projection system 208 that is within a threshold percentage (e.g., one percent to ten percent difference) of the current configuration of the projection system 208. In other examples, the controller 226 may generate (e.g., calculated based on historic data) an approximate list of magnifications Mₚᵣₒⱼ and constants of chromatic aberration C_{c}^{(proj)} to try for the current configuration (e.g., digital twin approximation involving simulation of the electron microscope system). In an example, the controller 226 may then set and record new setting values (e.g., in a temporary table or matrix) such as the constant of chromatic aberration for magnification M'ₚᵣₒⱼ for the new setting configuration in preparation for adjusting the optical component(s) 548.

At step 816, the controller 226 uses the multipole control component 554 to increase or decrease a voltage and/or current by a pre-calibrated amount (e.g., incremental or table defined) to one or more poles (e.g., magnetic poles) of the optical component 548 in the energy spectrometer 204 to generate new images in spectrum plane 307. In some examples, the multipole control component 554 increases or decreases the voltage and/or the current by using a correction matrix of optical component 548 pole voltages and/or currents based on a calibration of the projection system 208 and the energy spectrometer 204 at an earlier point in time. For example, based on observed effects (such as skewing, defocusing, and blurring in images 405/409), a correction matrix of specific currents for specific poles on individual optical components 548 may be generated to compensate for the observed effects. The correction matrix may be used in conjunction or independently of the look-up table.

At step 818, the controller 226 uses the defocus component 553 to determine if the new images are in focus, free of blurring, and/or chromatic aberrations. For example, if the new images contain similar optical aberrations as those shown in images 403, 405, 407, 409, then the new images are determined to be out of focus and the new settings are determined to be incorrect. If the new images are out of focus, the process returns to step 814 to re-measure the offset Δ*Z*'. If the new images are determined to be in focus (e.g., the offset Δ*Z*' 434 for the electron energy loss spectrum 541 is close to zero), the process 800 continues at step 820.

At step 820, the controller 226 records the new settings and new parameters (e.g., M'ₚᵣₒⱼ, C'_{c}^{(proj)}, multipole excitation settings etc.) in the look-up table for future use. In some examples, the controller 226 may update previous settings with newer, and more accurate, parameters. In other examples, the controller 226 may store the new parameters with additional variables such as temperature, date, manufacturing information associated with various components of the electron microscope system 500, or similar. For example, new calculated values of M'ₚᵣₒⱼ, C'_{c}^{(proj)} may be stored along with a current temperature (e.g., twenty-one degrees Celsius) to avoid duplicate settings which may occur when the electron microscope system 500 has experienced no physical configuration changes, but an environmental temperature has changed relative to the previous time the electron microscope system 500 was used (e.g., two months prior). The use of the additional variables may enhance the functionality of the electron microscope system 500 by reducing a time needed to focus images by using a more robust look-up table. Once the look-up table has been appropriately updated, the process 800 returns to step 810.

Returning now to step 812, if the controller 226 determines that the setting entered has already been used at a prior time, then the process 800 continues to step 822. At step 822, the controller 226 may retrieve configuration settings from the look-up table such as values of M'ₚᵣₒⱼ, C'_{c}^{(proj)}, and excitation parameters of the optical component 548 for imaging.

At step 824, the controller 226 uses the multipole control component 554 to increase or decrease a voltage and/or current to one or more poles of the optical component 548 (e.g., by using settings from the look-up table) in the energy spectrometer 204 to generate new images in spectrum plane 307.

At step 826, the controller 226 uses the defocus component 553 to determine if the new images are in focus, free of blurring, and/or chromatic aberrations. For example, if the new images contain similar optical aberrations as those shown in images 403, 405, 407, 409, then the new images may be determined to be out of focus and the new settings are determined to be incorrect. If the new images are out of focus, the process returns to step 814 to re-measure the offset Δ*Z'*. If the new images are determined to be in focus, the process 800 returns to step 810.

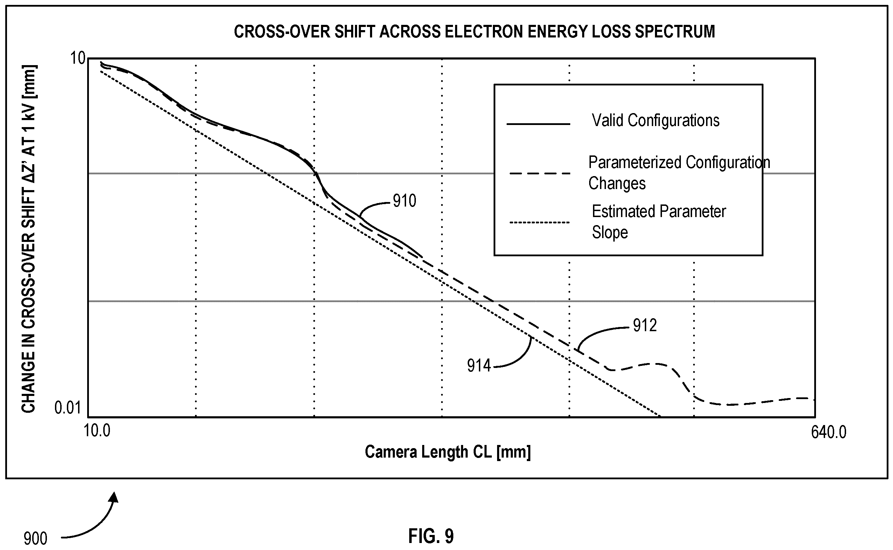

FIG. 9 is an example graph 900 for cross-over shifts across an energy loss spectrum, according to some embodiments. The graph 900 includes metrics relating to parameterized configuration changes 912, valid configurations 910, and an estimated parameterization slope 914 that may be calculated from the process 800 of Figure 8. The estimated parameterization slope 914 may represent a "best guess" for configuration of focusing using parameters such as values of Mₚᵣₒⱼ, C_{c}^{(proj)} as determined in step 705 of Figure 7 or step 814 of Figure 8. The estimated parameterization slope 914 may be used as a starting point for determining unknown values of Mₚᵣₒⱼ, C_{c}^{(proj)} for various configurations of the optical component 548 to reduce the time necessary to find a focus for the electron energy loss spectrum 541.

In some examples, as the process 800 of Figure 8 completes several iterative cycles (e.g., from a few to thousands of configurations) and obtains valid configurations for correcting a focus gradient of the electron energy loss spectrum 541 including values of magnification, constants of aberrations, pole configurations (e.g., voltages/currents) for the optical components 548, etc., data points for the valid configurations 910 line are populated and stored in a look-up table similar to, or the same as, the ones described in the process of Figure 7 or the process Figure 8. The valid configurations 910 line may represent a parameterization of configurations at the time of use that produced images that were in focus without blur or aberrations (e.g., focusing the electron energy loss spectrum 541 over hundreds of configurations). As more data points are discovered during the iterative process of Figure 8, the more the valid configurations 910 line will continue to grow to approximately, or exactly, match the parameterized configuration changes 912 line.

By way of example, the parameterized configuration changes 912 line represents all configurations of the electron microscope system 500 for each configuration of magnification (or camera length, as in FIG. 9), energy loss, constant(s) of chromatic aberrations, etc. as the valid configurations are stored in the look-up table using the process of Figure 7 (e.g., a line representing all valid configurations which focus the electron energy loss spectrum 541). The parameterized configuration changes 912 line may be dependent on the magnification of the magnification elements 333, the power and configuration of the objective lens 332, the amount of the adjustment to the magnification, M_{proj,} of the projection system 208, a constant of chromatic aberration C_{c}^{(proj)} of the projection system 208, the energy *E*₀ of the primary electron beam 505, a total energy spread ΔE of the electron energy loss spectrum, or combinations thereof. When the process 800 of Figure 8 determines an offset ΔZ', the controller 226 may determine a corresponding configuration based on the parameterized configuration changes 912 line to focus the electron energy loss spectrum 541 correctly.

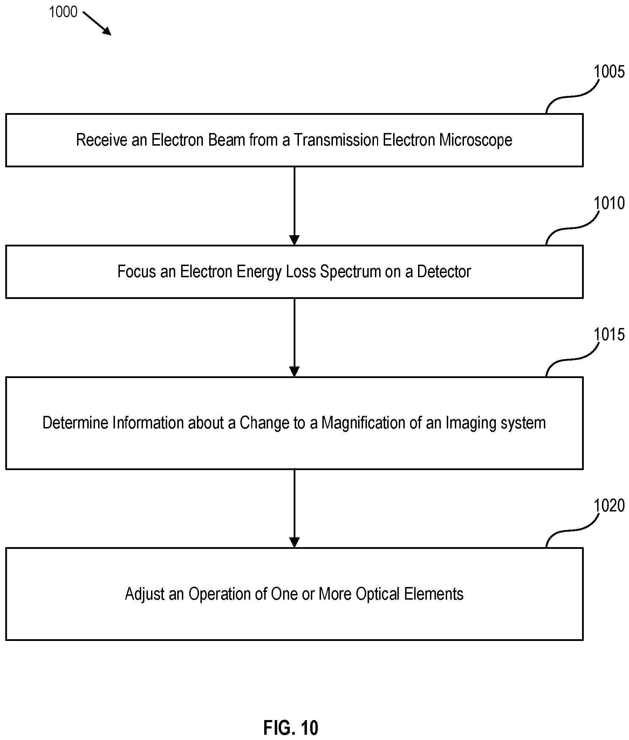

FIG. 10 is a flow diagram of an example process 1000 for operating a transmission electron microscope with an electron microscope system, according to some embodiments. The electron microscope system may be an example of other electron microscope system described herein, including microscope system 100 of FIG. 1. The electron microscope system can include a computer system configured to carry out the operations of processes 700, 800, and 1000. For example, a computer system may be configured to adjust the parameters of the electron beam (e.g., accelerating potential, beam focus parameters, beam current, beam deflection, etc.), the scanning/imaging parameters for SEM and/or STEM modes (e.g., sweep time, dwell time, etc.), detector settings (e.g., biasing voltage, collector grid voltage, etc.), and other suitable parameters for the operation of such a microscopy system. The computer system can be a single system that controls operations of both a microscope and an energy spectrometer or the computer system can involve multiple systems that control the operations of the microscope and energy spectrometer separately.

At block 1005, the process 1000 involves receiving an electron beam from a transmission electron microscope. The electron beam can be received by the energy spectrometer. The transmission electron microscope can include an imaging system arranged after a sample plane. The electron beam can include an energy loss spectrum due to an interaction with a sample. For example, a sample in the sample plane can be interrogated with an electron beam of a desired energy (e.g., a primary beam energy) and some of the electrons exiting from the sample have reduced energy characteristic of various properties of the sample leading to the electron energy loss spectrum in the electron beam. Energy dependent defocus can occur when the electron energy loss spectrum passes through the imaging system or other components of the transmission electron microscope or energy spectrometer.

At block 1010, the process 1000 involves focusing the electron energy loss spectrum on a detector. Focusing the electron energy loss spectrum can involve controlling operations of optical components in the energy spectrometer. For example, the optical components can include multipoles. Controlling the operations of the optical components can involve causing the multipoles to apply electromagnetic fields to affect charged particles in the electron energy loss spectrum.

At block 1015, the process 1000 involves determining information about a change to a magnification of the imaging system. The imaging system can include a plurality of lenses, such as magnetic lenses and/or magnetic quadrupoles. The information can involve a contribution to an energy dependent defocus caused by the change in magnification. In some examples, the information can be pre-stored by a TEM and can associate chromatic or energy dependent defocus with the change to the magnification (e.g., the change in magnification value, a change in camera length associated with the imaging system, etc.). The information can be sent from the TEM to a controller for the energy spectrometer. The information can be based on a deliberate magnification change initiated by a user or based on a magnification change due to environmentally caused instrument drift. The change in magnification can cause the electron energy loss spectrum to become defocused on the detector.

At block 1020, the process 1000 involves adjusting an operation of one or more optical components such that at least a portion of the electron energy loss spectrum is refocused onto the detector. In some examples, the entire energy loss spectrum can be refocused onto the detector. The adjustment of the one or more optical components can depend on parameters of the microscope or the energy spectrometer. In some examples, the controller can adjust the operation of the one or more optical components by determining an amount of defocus. The parameters can include the amount of the adjustment to the magnification, an energy *E*₀ of a primary electron beam in the electron energy loss spectrum, a total energy spread ΔE of the electron energy loss spectrum, etc. In some examples, the controller can calculate the amount of defocus based on the parameters. The one or more optical components can include multipoles, such as hexapoles or octupoles. Adjusting the operation of the one or more optical components can involve changing electromagnetic fields applied by one or more optical components.

In some examples, the total energy spread ΔE can be compared to a predetermined threshold value for energy spread. The comparison can assist in determining adjustments of operations of multiple optical components. For example, if the total energy spread ΔE is less than the predetermined threshold value, then adjusting the operations can involve adjusting the operations of at least one hexapole. If the total energy spread ΔE is more than the predetermined threshold value, then adjusting the operations can involve adjusting the operations of at least one hexapole and at least one octupole.

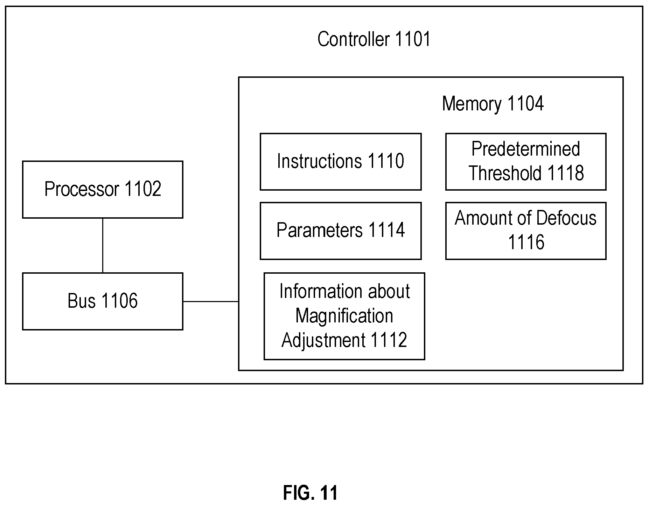

FIG. 11 is a block diagram of a controller 1101 for an electron microscope system according to certain aspects of the present disclosure. Examples of the electron microscope system can include microscope system 100 from FIG. 1. As shown, the controller 1101 includes a processor 1102 communicatively coupled to memory 1004. The processor 1102 can include one processing device or multiple processing devices. Non-limiting examples of the processor 1102 include a Field-Programmable Gate Array (FPGA), an application specific integrated circuit (ASIC), a microprocessor, or any combination of these. The processor 1102 can execute instructions 1110 stored in the memory 1004 to perform operations, such as the operations of process 700 from FIG. 7, process 800 from FIG. 8, or process 1000 from FIG. 10. In some examples, the instructions 1110 can include processor-specific instructions generated by a compiler or an interpreter from code written in any suitable computer-programming language, such as C, C++, C#, Python, or Java.

The memory 1004 can include one memory device or multiple memory devices. The memory 1004 can be non-volatile and may include any type of memory device that retains stored information when powered off. Non-limiting examples of the memory 1004 include electrically erasable and programmable read-only memory (EEPROM), flash memory, or any other type of non-volatile memory. At least some of the memory 1004 can include a non-transitory computer-readable medium from which the processor 1102 can read instructions 1110 via bus 1106. The bus 1106 may be a communication and/or power bus that enables processor 1102 to communicate with memory 1004. The non-transitory computer-readable medium can include electronic, optical, magnetic, or other storage devices capable of providing the processor 1102 with the instructions 1110 or other program code. Non-limiting examples of the non-transitory computer-readable medium include magnetic disk(s), memory chip(s), RAM, an ASIC, or any other medium from which a computer processor can read instructions 1110.

The memory 1004 can further include information about magnification adjustment 1112, parameters 1114, amount of defocus 1116, and a predetermined threshold 1118. The controller 1101 can receive the information about a magnification adjustment from a microscope, such as a TEM. At least some of the information about magnification adjustment 1112 can be pre-stored and can be associated with a chromatic defocus correction for a defocus caused by the change in magnification. The parameters 1114 can include operating parameters associated with an electron microscope system, such as a desired energy/primary energy of an electron beam, an energy spread of an energy loss spectrum, etc. The controller can determine or calculate the amount of defocus 1016 based on the magnification adjustment 1112 and the parameters 1114. In some examples, some of the parameters 1114 can be compared to the predetermined threshold 1118. The comparison may determine how the amount of defocus 1116 is determined. The amount of defocus 1116 can be used to adjust operations of optical components in an energy spectrometer.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on electron microscopy systems, and TEM/EELS systems in particular, these are meant as non-limiting, illustrative embodiments. Embodiments of the present disclosure are not limited to such materials, but rather are intended to address electron beam systems for which a wide array of particles can be applied to imaging, microanalysis, and/or processing of materials on an atomic scale. Such particles may include, but are not limited to, electrons, ions, or photons in TEM systems, SEM systems, STEM systems, ion beam systems, and/or particle accelerator systems.

Some embodiments of the present disclosure include a system including one or more data processors and/or logic circuits. In some embodiments, the system includes a non-transitory computer readable storage medium containing instructions which, when executed on the one or more data processors, cause the one or more data processors to perform part or all of one or more methods and/or part or all of one or more processes and workflows disclosed herein. Some embodiments of the present disclosure include a computer-program product tangibly embodied in a non-transitory machine-readable storage medium, including instructions configured to cause one or more data processors to perform part or all of one or more methods and/or part or all of one or more processes disclosed herein, including, for example, process 1000 of FIG 10.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "about" or "substantially" are used to indicate a deviation from the stated property or numerical value within which the deviation has little to no influence of the corresponding function, property, or attribute of the structure being described. In an illustrated example, where a dimensional parameter is described as "substantially equal" to another dimensional parameter, the term "substantially" is intended to reflect that the two dimensions being compared can be unequal within a tolerable limit, such as a fabrication tolerance. Similarly, where a geometric parameter, such as an alignment or angular orientation, is described as "about" normal, "substantially" normal, or "substantially" parallel, the terms "about" or "substantially" are intended to reflect that the alignment or angular orientation can be different from the exact stated condition (e.g., not exactly normal) within a tolerable limit. For dimensional values, such as diameters, lengths, widths, or the like, the term "about" can be understood to describe a deviation from the stated value of up to ±10%. For example, a dimension of "about 10 mm" can describe a dimension from 9 mm to 11 mm. In the present disclosure, "sub-ranges" refers to a range of values between the two stated extents and/or including one of the two stated extents.

The description provides exemplary embodiments, and is not intended to limit the scope, applicability or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims.

Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

## Claims

1. A method implemented by an electron microscope system, the method comprising:
receiving an electron beam from a transmission electron microscope, the transmission electron microscope including an imaging system arranged after a sample plane, the electron beam including an electron energy loss spectrum due to an interaction with a sample;
focusing, by optical components of the electron microscope system, the electron energy loss spectrum on a detector;
determining information about a change to a magnification of the imaging system; and
adjusting, based on the change to the magnification, an operation of one or more of the optical components such that variation to a focus across at least a portion of the electron energy loss spectrum is corrected and at least the portion of the electron energy loss spectrum is refocused onto the detector.

2. The method of claim 1, wherein determining information about the change to the magnification of the imaging system further comprises:
providing the information to a controller connected to the one or more optical components, wherein the information is provided to the controller by the transmission electron microscope; and
wherein adjusting the operation of the one or more optical components further comprises:
retrieving at least one setting from a look-up table based on the change to the magnification; and
controlling the operation of the one or more optical components to adjust at least one magnetic pole of the one or more optical components based on the at least one setting.

3. The method of claim 2, wherein adjusting the at least one magnetic pole of the one or more optical components compensate for a defocus across the electron energy loss spectrum.

4. The method of claim 3, wherein the information is pre-stored by the transmission electron microscope and associates a chromatic defocus correction with the change to the magnification.

5. The method of claim 2, wherein the information is sent from the transmission electron microscope based on the change to the magnification of the imaging system.

6. The method of claim 1, wherein the change to the magnification is associated with a shift to a cross-over point at an end of the transmission electron microscope, and wherein the operation of one or more of the optical components is adjusted such that a shift to a focal point across the electron energy loss spectrum is corrected, wherein the shift to the focal point is caused by the shift to the cross-over point.

7. The method of claim 1, the method further comprising:
determining, based on the information, a shift to a cross-over point at an end of the transmission electron microscope, wherein the operation of one or more of the optical components is adjusted based on the shift.

8. The method of claim 2, wherein the information includes a value for chromatic defocus correction, and further comprising:
determining, based on the value, a shift to a cross-over point at an end of the transmission electron microscope, wherein the operation of one or more of the optical components is adjusted based on the shift.

9. The method of claim 8, wherein an association between the value and the shift is pre-stored by the controller in the look-up table.

10. One or more computer-readable storage media storing instructions that, upon execution by one or more processors of an energy spectrometer, cause the energy spectrometer to perform operations comprising:
receiving an electron beam from a transmission electron microscope, the transmission electron microscope including an imaging system arranged after a sample plane, the electron beam including an electron energy loss spectrum due to an interaction with a sample;
focusing, by optical components of the energy spectrometer, the electron energy loss spectrum on a detector;
determining information about a change to a magnification of the imaging system; and
adjusting, based on the change to the magnification, an operation of one or more of the optical components such that variation to a focus across at least a portion of the electron energy loss spectrum is corrected and at least the portion of the electron energy loss spectrum is refocused onto the detector.

11. The one or more computer-readable storage media of claim 10, the operations further comprising:
determining, based on the information, an adjustment to a multipole of the one or more of the optical components, wherein adjusting the operation of one or more of the optical components includes applying the adjustment to the multipole.

12. The one or more computer-readable storage media of claim 11, the operations further comprising:
determining, based on the information, a shift to a cross-over point at an end of the transmission electron microscope, wherein the adjustment is determined based on the shift.

13. The one or more computer-readable storage media of claim 12, wherein an association between the adjustment and the shift is pre-stored by the energy spectrometer.

14. The one or more computer-readable storage media of claim 11, wherein the adjustment causes a change to an electromagnetic field applied by the multipole.

15. The one or more computer-readable storage media of claim 11, wherein the adjustment is determined based on a correction matrix defined based on a calibration of the imaging system and the energy spectrometer.

16. The one or more computer-readable storage media of claim 11, wherein adjusting the operation of one or more of the optical components includes adjusting a first operation of a first multipole disposed prior to a spectrum plane of the energy spectrometer and adjusting a second operation of a second multipole disposed post the spectrum plane.

17. An apparatus comprising:
an energy spectrometer coupled to a transmission electron microscope to acquire one or more energy loss spectra, the transmission electron microscope including an imaging system arranged after a sample plane, the energy spectrometer including:
optical components configured to focus an electron energy loss spectrum on a detector;
the detector arranged conjugate to a spectrum plane; and
a controller configured to determine a change to a magnification of the
imaging system and adjust, based on the change to the magnification, an operation of one or more of the optical components such that at least a portion of the electron energy loss spectrum is corrected and at least the portion of the electron energy loss spectrum is refocused onto the detector.

18. The apparatus of claim 17, wherein adjusting the operation includes controlling a hexapole of the one or more of the optical components based on an energy loss being smaller than a threshold value.

19. The apparatus of claim 17, wherein adjusting the operation includes controlling an octupole of the one or more of the optical components based on an energy loss being larger than a threshold value.

20. The apparatus of claim 17, wherein the change to the magnification is determined by at least receiving, by the controller, information about the change from the transmission electron microscope, wherein the information indicates a value for a chromatic defocus correction, wherein the controller is further configured to:
determine, based on the value, a shift to a cross-over point at an end of the transmission electron microscope, wherein adjusting the operation includes changing an electromagnetic field of a multipole of the one or more of the optical components based on the shift.
